(19) Europäisches Patentamt

European Patent Office

Office européen des brevets

(11) Numéro de publication: **0 228 735 B1**

(12) **FASCICULE DE BREVET EUROPEEN**

(45) Date de publication de fascicule du brevet: **13.05.92**

(51) Int. Cl.⁵: **G03B 15/00**, G03F 7/20, H01J 29/18

(21) Numéro de dépôt: **86202182.1**

(22) Date de dépôt: **01.12.86**

Le dossier contient des informations techniques présentées postérieurement au dépôt de la demande et ne figurant pas dans le présent fascicule.

(54) **Dispositif d'insolation pour la génération de masques.**

(30) Priorité: **10.12.85 FR 8518230**

(43) Date de publication de la demande:
**15.07.87 Bulletin 87/29**

(45) Mention de la délivrance du brevet:
**13.05.92 Bulletin 92/20**

(84) Etats contractants désignés:
**AT CH DE FR GB LI**

(56) Documents cités:
**US-A- 2 951 177**
**US-A- 3 531 674**
**US-A- 3 634 621**
**US-A- 3 809 888**

**PATENTS ABSTRACTS OF JAPAN, vol. 7, no. 94 (E-171)[1239], 20 avril 1983; & JP-A-58 18 923**

(73) Titulaire: **LABORATOIRES D'ELECTRONIOUE PHILIPS**
**3, Avenue Descartes**
**F-94450 Limeil-Brévannes(FR)**

(84) Etats contractants désignés:
**FR**

(73) Titulaire: **N.V. Philips' Gloeilampenfabrieken**
**Groenewoudseweg 1**
**NL-5621 BA Eindhoven(NL)**

(84) Etats contractants désignés:
**CH DE GB LI AT**

(72) Inventeur: **Duchenois, Valère**
**Société Civile S.P.I.D. 209, rue de l'université**
**F-75007 Paris(FR)**

(74) Mandataire: **Landousy, Christian et al**
**Société Civile S.P.I.D. 156, Boulevard Haussmann**
**F-75008 Paris(FR)**

## Description

L'invention concerne un dispositif d'insolation pour la génération de masques à partir d'un système de conception assistée par ordinateur, qui comprend :

- un tube à rayons cathodiques qui fournit une image du masque optique sur l'écran de tube,
- et un système optique qui projette l'image du masque sur un support à insoler.

Un tel dispositif trouve son application dans la fabrication des dispositifs à semiconducteurs, dans les technologies à couches minces et à couches épaisses, dans la fabrication photographique...

Une invention de ce genre est connue du document JP 58.18923 qui décrit un dispositif formé d'un tube à rayons cathodiques présentant un écran de verre, muni d'un luminophore, devant lequel est placé une plaque de fibres optiques destinées à capter les rayons lumineux issus de l'écran et à les conduire sous forme de faisceaux parallèles. Un substrat placé à la sortie de la plaque de fibres optiques est ainsi insolé par la lumière issue de l'écran sur lequel apparaît le motif géométrique du masque généré à l'aide d'un système de conception assisté par ordinateur. Ce dispositif semble prévu pour exploiter le plus directement possible l'image du masque telle qu'elle apparaît sur la console de visualisation du système de conception par ordinateur.

Or ce dispositif présente des inconvénients. Tout d'abord le grandissement du système ne peut être qu'égal à 1, l'image projetée ayant les mêmes dimensions que l'image de l'écran. De plus, l'écran du tube et la plaque de fibres optiques étant en verre, le spectre émis par la couche photosensible ne peut se situer que dans le domaine visible. La définition finale de l'image projetée est donc limitée du fait de la longueur d'onde élevée de la lumière. Egalement, le tube à rayons cathodiques utilisé étant d'un type standard, donc adapté à la vision humaine, présente une brillance faible, mal adaptée à un dispositif d'insolation, ce qui conduit à des durées d'insolation élevées et accroît les erreurs de restitution.

On connaît également le document US-A 3 531 674 qui décrit un tube à rayons cathodiques que l'on équipe de moyens en vue de refroidir l'écran pour qu'il puisse supporter une densité de courant élevée sans subir d'échauffement néfaste à un fonctionnement correct du tube. L'idée de base est d'équiper le tube d'un circuit de refroidissement parcouru par un fluide. L'échange thermique sera d'autant mieux assuré que le matériau constituant le support d'écran est bon conducteur de la chaleur.

On connaît encore le document US-A 2 951 177 qui décrit un tube à mémoire ayant un canon pour écrire sur une grille et un canon "flood" de lecture. Il s'agit d'une structure classique qui présente en luminosité les performances très limitées des tubes de sa génération. Les courants d'excitation sont faibles, ce qui ne provoque aucun échauffement nécessitant un refroidissement de l'écran. Ce tube est très éloigné des critères modernes de haute brillance.

Tous ces documents se rapportent indépendamment à des situations qui tiennent compte de la vision humaine, c'est-à-dire que les aspects d'intensité lumineuse, de taille de spot sur l'écran, de domaine de longueurs d'onde... mettent à profit les "imperfections" de l'oeil humain. Les performances des tubes sont donc limitées par ces bornes naturelles. Or si l'on désire utiliser un autre récepteur que l'oeil humain, les bornes s'élargissent pour tous les aspects énoncés. Il faut alors disposer d'un maximum de lumière concentrée sur un spot mobile de très faibles dimensions avec des spectres d'émission déplacés vers les courtes longueurs d'onde (vers l'ultraviolet) pour des questions de définition du spot lumineux perçu par ce récepteur.

Le but de l'invention est donc de permettre l'insolation de masques avec des possibilités de grandissement et de dégrandissement. Il est également de donner à l'image projetée finale une définition spatiale suffisante compatible avec les applications visées, tout en réduisant considérablement la durée d'exposition.

Pour cela l'invention telle que définie dans le préambule est remarquable en ce que :
le tube à rayons cathodiques est un tube à haute brillance dont l'écran est muni premièrement d'un luminophore émettant dans l'ultraviolet, et deuxièmement d'un circuit de refroidissement du luminophore,
et en ce que le système optique est un système optique pour l'ultraviolet qui opère sur l'image ultraviolette fournie par l'écran du tube à haute brillance.

L'invention met à profit les techniques de plus en plus répandues consistant à réaliser les masques pour l'implantation d'un circuit électronique à l'aide d'un ordinateur.Les techniques traditionnelles, qui n'exploitent pas directement l'image formée sur l'écran, font appel à la réalisation d'un masque intermédiaire sur un support solide. Cette étape est supprimée dans l'invention.

Lorsque le circuit électronique est implanté, on dispose d'une image sur l'écran d'une console de visualisation. L'image qui y est formée sert à l'utilisateur pour effectuer la mise au point de l'implantation du circuit. Son utilisation directe présente des inconvénients qui viennent d'être analysés.

Lorsque la mise au point du dessin est achevée, on branche électriquement, conformément à l'invention, un tube à haute brillance en parallèle sur la console de visualisation en utilisant les mêmes signaux de balayage et de synchronisation. Ce tube à haute brillance présente généralement des dimensions réduites, par exemple 90x70mm. L'écran du tube à haute brillance est recouvert intérieurement d'un luminophore qui émet dans l'ultraviolet par exemple entre 365 nm et 400 nm.

Par comparaison avec la lumière visible ces longueurs d'onde plus faibles permettent d'accroître la finesse du dessin de l'image finale. L'image formée sur l'écran du tube à haute brillance est reprise par un système optique adapté à l'ultraviolet. Il peut assurer un grandissement, un dégrandissement ou un simple transfert de l'image selon le but poursuivi.

Pour faciliter l'utilisation du dispositif d'insolation en ce qui concerne les insolations successives de masques différents, on place à la périphérie de l'écran du tube à haute brillance, hors du champ utile, des repères servant à faciliter la superposition des images successives. Ces repères sont constitués de petits motifs d'un luminophore émettant dans le visible. Le système optique est corrigé pour laisser passer la lumière émise dans le visible.

Le tube à haute brillance et le système optique sont fixés solidairement dans un châssis.

Pour réaliser l'insolation, il est nécessaire de disposer d'une image fixe pendant la durée de cette insolation avec des fluctuations de position réduites. L'utilisation d'un tube à haute brillance en fournissant un flux lumineux élevé permet une réduction substantielle du temps d'exposition.

Pour assurer la persistance de l'image sur l'écran, selon une première variante préférentielle, le tube à haute brillance est un tube à mémoire, qui comprend un canon d'écriture, un ou plusieurs canons d'arrosage, des moyens de collimation et une grille métallique recouverte d'un isolant qui se charge localement de charges électrostatiques. Il est ainsi possible d'écrire une image électronique latente sur cette grille, à l'aide du canon d'écriture qui est ensuite lue avec les canons d'arrosage appropriés. Ceci permet de disposer d'une puissance électrique accrue donc d'une image plus lumineuse et mieux contrastée.

Pour atteindre les performances en haute brillance sans aberrations d'image, le tube délivre une densité de puissance électrique d'excitation du luminophore pouvant atteindre une valeur au moins égale à sensiblement 2 watts/cm$^2$, le canon d'arrosage fournissant une densité de courant homogène inférieure à 0,025 A/cm$^2$ dans le plan de sortie du canon d'arrosage.

Selon une seconde variante on utilise un tube à haute brillance, ne possédant pas de mémorisation. Dans ce cas, la persistance de l'image est assurée en effectuant un balayage récurrent de l'image.

Dans ces deux variantes, compte tenu de la puissance électrique dissipée, le tube à haute brillance est muni d'un circuit de refroidissement de l'écran.

En adaptant aux applications le système optique pour l'ultraviolet, il est possible d'assurer un grandissement, un dégrandissement ou un simple transfert à échelle unité de l'image. Il est donc possible de réaliser des masques en insolant des laques photosensibles déposées sur des substrats tels que des dispositifs à semiconducteur ou autres.

L'invention sera mieux comprise à l'aide des dessins, donnés à titre d'exemples non limitatifs qui représentent :

figure 1 : un schéma du dispositif d'insolation selon l'invention couplé à un système de conception assisté par ordinateur,

figure 2 : une courbe d'émission d'un luminophore émettant dans l'ultraviolet,

figure 3 : un dessin d'un tube à haute brillance muni d'une grille mémoire et d'un luminophore émettant dans l'ultraviolet.

figure 4 : une représentation des trajectoires électroniques d'un canon d'arrosage.

figure 5 : une représentation des trajectoires électroniques des moyens de collimation.

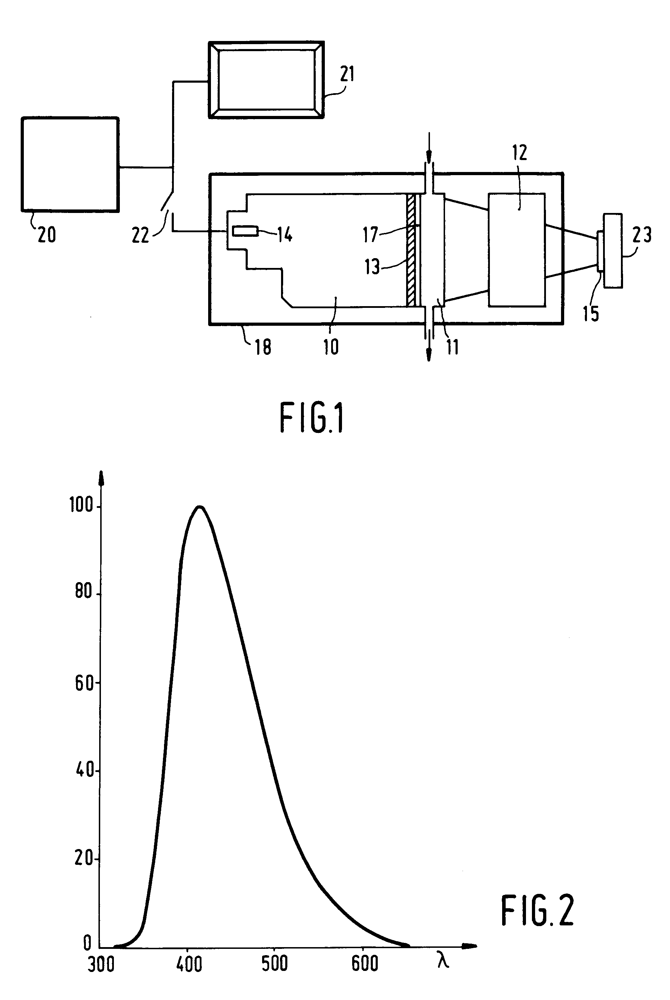

On a représenté sur la figure 1, un système de conception assisté par ordinateur représenté symboliquement par un ordinateur 20 et une console de visualisation 21, tels qu'ils sont utilisés selon l'art antérieur.

L'opérateur effectue la mise au point de son tracé de la manière habituelle. Lorsque cette étape est achevée le dispositif d'insolation selon l'invention est alors connecté en parallèle sur la console de visualisation 21, à l'aide d'un contacteur 22. L'invention comprend un châssis 18 dans lequel sont disposés un tube à haute brillance 10 et un système optique pour ultraviolet 12. Le tube à haute brillance 10 est muni sur sa face de sortie d'un luminophore 13 émettant un rayonnement ultraviolet. Ce luminophore 13 est excité par les électrons issus du canon à électrons 14. Le tube à haute brillance est prévu pour fonctionner avec des courants de faisceaux élevés, ce qui nécessite de refroidir son écran à l'aide d'un circuit de refroidissement 11 dans lequel circule un fluide.

Le tube à haute brillance selon l'invention permet de diminuer les temps d'exposition tout en utilisant les laques sensibles dans l'ultraviolet disponibles commercialement, par exemple la laque n° 1350 de la Société SHIPLEY (Etats-Unis). Avec une dynamique en tout ou rien obtenue en modulant le wehnelt du tube, d'une manière bistable, on obtient un contraste maximal, ce qui est un avantage de l'invention. Il est de plus possible d'inverser la polarité du signal de vidéo, ce qui permet d'obtenir un masque représentant une image positive ou une image négative et ceci sans avoir besoin de changer de type de laque.

Le faisceau lumineux qui sort du tube à haute brillance muni de son circuit de refroidissement pénètre dans un système optique pour ultraviolet 12 qui fournit une image sur un substrat 15 positionné par rapport au système optique par un ensemble micromanipulateur 23.

Le système optique est à adapter à la courbe d'émission du luminophore. Ainsi pour une longueur d'onde d'émission de 405 nm, il est possible d'utiliser des objectifs S. Planar n° 107739 ou n° 107751 de la Société CARL ZEISS (Allemagne Fédérale).

Le luminophore peut être constitué d'un luminophore de type P5, tels ceux fabriqués par les Sociétés RIEDEL DE HAEN (DE), DERBY LUMINESCENT (GB), HS RADIUM (US), dont la courbe d'émission est représentée sur la figure 2 entre 300 nm et 600 nm.

Afin de faciliter la superposition de masques successifs, on réalise des repères de positionnement constitués de petits plots de luminophore émettant dans le visible qui se substituent à ces endroits au luminophore de base. Ces repères sont disposés à la périphérie de l'écran. Pour cela le système optique est corrigé dans le visible pour laisser passer une longueur d'onde spécifique, par exemple le vert, afin qu'il soit possible visuellement de positionner des masques successifs.

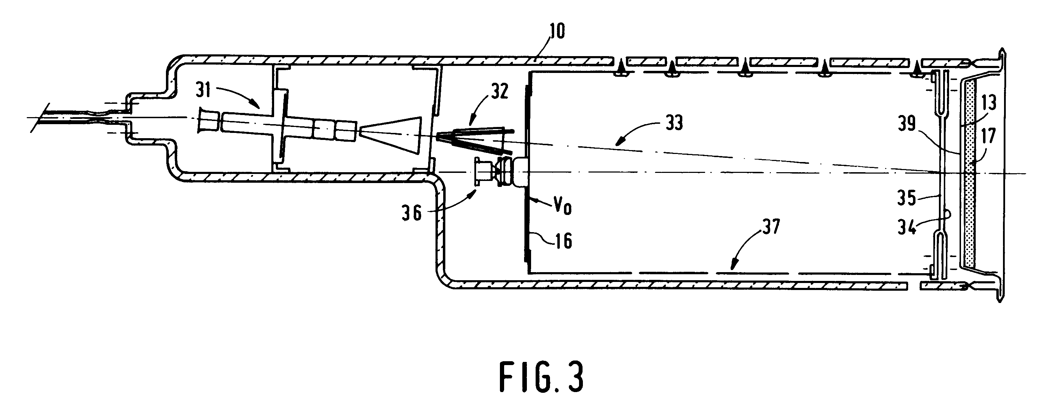

Selon une variante préférentielle de l'invention, le tube à haute brillance est un tube à mémoire tel que représenté schématiquement sur la figure 3.

Le tube à haute brillance 10 comprend un canon d'écriture 31 qui fournit un faisceau d'électrons focalisé par des grilles internes au canon et défléchi par des plaques 32 ou des bobines, selon un faisceau d'électrons d'écriture 33. Ce faisceau arrive sur une grille à mémoire 34 qui a un pas fin d'environ 60 micromètres et une transparence d'environ 50%. Le diamètre du faisceau d'électrons d'écriture 33 est d'environ 30 micromètres au niveau de la grille à mémoire 34 avec des électrons ayant une énergie de l'ordre de $2,4.10^{-16}$ J (1500 eV). Cette grille présente, du coté où arrive le faisceau 33, une fine couche d'oxyde, par exemple 4 à 5 micromètres d'oxyde de magnésium qui présente la propriété d'émettre des électrons secondaires. Ceci se traduit par la fixation de charges électrostatiques sur la grille mémoire motivant son appellation. Les électrons secondaires émis sont collectés par une grille collectrice 35 placée juste devant la grille à mémoire, entre celle-ci et les plaques 32. Cette grille collectrice 35 est à pas très lâche (environ 600 micromètres) et à haute transparence (environ 80%). Elle sert également à définir le champ électrique de l'espace grille collectrice-grille mémoire-écran afin de définir la dynamique de brillance de l'image.

Après l'écriture, l'étape suivante du fonctionnement d'un tube à mémoire consiste à lire les charges électrostatiques présentes sur la grille à mémoire. Ceci s'effectue à l'aide de un ou plusieurs canons d'arrosage 36 (flood en anglais) qui opèrent avec des courants bien plus élevés que celui délivré par le canon 31. Le faisceau d'électrons de lecture est très uniforme et bien collimaté, par des moyens de collimation 37, avec des électrons de faible énergie, environ 8 à 9,6. $10^{-19}$ J (5 à 6 eV). Ainsi, avec un courant de 10 mA délivré par les canons d'arrosage, une tension entre écran et grille mémoire de 30 kV et une transparence de grille mémoire de 50% on obtient une puissance électrique de 150 watts dissipée sur l'écran.

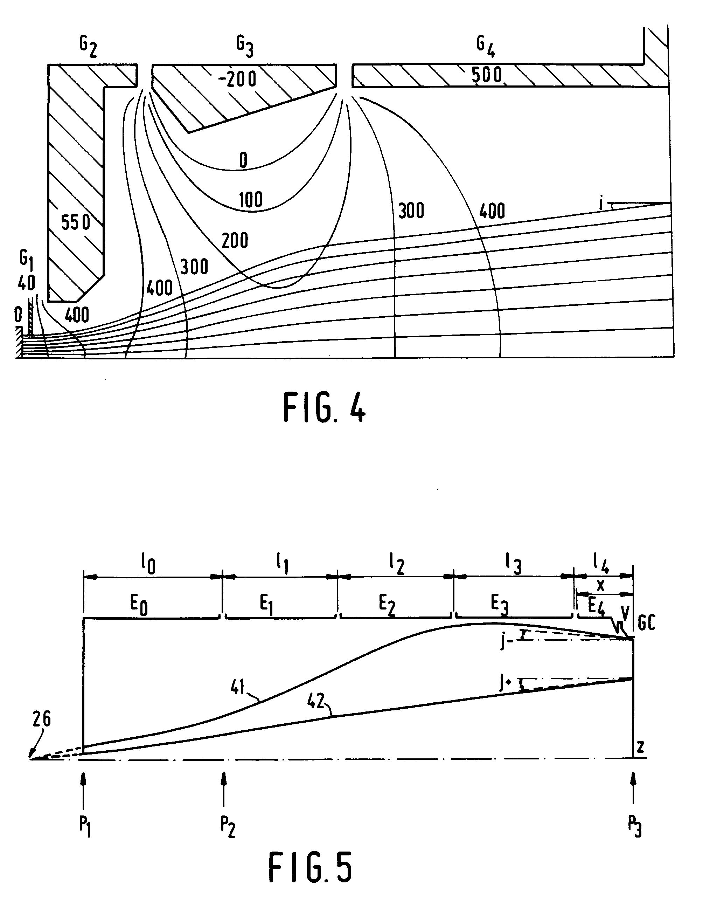

La figure 4 représente les trajectoires électroniques et les répartitions de potentiel d'un canon d'arrosage utilisable dans un tube à haute brillance à mémoire. Compte tenu de la symétrie du canon, seule une coupe de la moitié du canon est représentée. A titre d'exemple, pour un courant de 20 mA les quatre électrodes G1, G2, G3, G4 sont portées aux potentiels suivants, par rapport à la cathode :

$VG_1$ = 40 volts ; $VG_2$ = 550 volts ;
$VG_3$ = -200 volts ; $VG_4$ = 500 volts.

La géométrie de l'ensemble "cathode-électrode G1-électrode G2" et le choix des potentiels relatifs $VG_2/VG_1$ définissent des conditions d'émission homogène, voisines de celles d'une diode à électrodes planes parallèles, car ils définissent une configuration des potentiels telle que le plan sensiblement médian de l'électrode mince G1 est de potentiel uniforme $VG_1$. Le potentiel $VG_1$ et l'ouverture de l'électrode G2 définissent une lentille divergente pour le faisceau. L'électrode G3, associée aux deux électrodes G2 et G4 forme avec celles-ci une lentille convergente qui réduit l'angle d'ouverture du faisceau dont le diamètre a préalablement été élargi par la lentille divergente précédente. L'angle i, dans le plan de sortie du canon, est ainsi réduit à une valeur inférieure à sensiblement 8°. Pour cela le potentiel $VG_3$ de l'électrode G3 est négatif par rapport à la cathode placée au potentiel VK = 0. Si l'on désire utiliser le tube avec des flux lumineux inférieurs à ses performances maximales, il est possible de réduire le potentiel négatif $VG_3$ et même de le rendre égal au potentiel VK de la cathode.

Avantageusement, le potentiel VK est inférieur au potentiel VG1 de l'électrode G1, lui-même inférieur au potentiel VG$_2$ de la grille G2.

La figure 5 est une représentation simplifiée des trajectoires électroniques des moyens de collimation. Le plan d'entrée des moyens de collimation coïncide sensiblement avec le plan de sortie P1 du canon d'arrosage. Dans ce plan les trajectoires électroniques semblent issues d'une source ponctuelle virtuelle 26 caractérisant le canon d'arrosage. A l'intérieur des moyens de collimation deux trajectoires caractéristiques 41, 42 sont représentées. La trajectoire 42 a une pente toujours croissante et présente dans le plan de sortie P3 une inclinaison j$_+$ caractérisant une courbe située sous la normale au point d'impact. La trajectoire 41 a une pente croissante suivie d'une pente décroissante. Cette trajectoire 41 présente une inclinaison j- caractérisant une trajectoire située au-dessus de la normale au point d'impact. Cette trajectoire 41 montre l'influence des potentiels appliqués aux électrodes des moyens de collimation qui collimatent les trajectoires électroniques sur le plan de sortie.

Des trajectoires électroniques qui seraient interceptées par les électrodes, E0, E1, E2, E3 ou E4 qui constituent les moyens de collimation, donneraient alors naissance à des courants dans ces électrodes qui seraient ainsi perdus pour l'image finale. Afin d'éviter cette perte de courant dans les électrodes et d'assurer aux inclinaisons j+ et j- une valeur inférieure à sensiblement 2°, les moyens de collimation sont réalisés de la manière suivante.

La première électrode EO est constituée d'une bague cylindrique de rayon RO = 71,5 mm et de longueur LO sensiblement égale à RO afin de blinder les trous de sortie des canons vis à vis des champs des moyens de collimation. Dans l'exemple choisi, son potentiel est d'environ 500 volts puisqu'il représente le potentiel de sortie du canon d'arrosage.

Les électrodes E1, E2, E3 sont sensiblement identiques. Elles sont constituées d'une bague cylindrique de rayons R1 = R2 = R3 = 71,5 mm. Leurs longueurs sont voisines.

L'électrode E4 a une forme de coupelle de rayon R4 = R3 sur laquelle la grille collectrice est montée à l'aide d'un cadre rectangulaire. La demi-diagonale utile est de l'ordre de 60 mm sur l'étendue de laquelle les moyens de collimation doivent opérer. Préférentiellement, le potentiel de l'électrode E4 est identique au potentiel VGC de la grille collectrice. La profondeur x de la coupelle constituant cette électrode finale E4 est x = 27 mm, de sorte que x/R vaut sensiblement 0,38, ce qui confère à la lentille de collimation ses qualités dans un large domaine de variation des potentiels selon les variantes d'utilisation.

Les potentiels des électrodes E0, E1 sont supérieurs au potentiel VGC, ce qui définit une optique globalement décélératrice. De la sorte, les électrons issus du canon d'arrosage et réfléchis par la grille à mémoire, traversant à nouveau la grille collectrice proportionnellement à la transparence, n'y seront pas finalement repoussés : ils sont essentiellement collectés par les électrodes E0 et E1, ce qui évite tout échauffement de la grille collectrice.

Dans cette optique, les potentiels V2 et V3 des électrodes E2 et E3 peuvent être inférieurs à VGC.

Lorsque l'image latente a été inscrite sur l'isolant de la grille mémoire à l'aide du canon d'écriture, elle doit être lue par le canon d'arrosage. Les électrons qui traversent la grille collectrice placée par exemple au potentiel VGC = 200 volts pénètrent dans le champ de la grille mémoire. Celle-ci a son support métallique polarisé à une valeur VGS qui correspond au cut-off du faisceau d'arrosage en absence d'image inscrite (état initial). Typiquement, VGS = -5 à -8 volts par rapport à la cathode, selon la géométrie de la grille et évidemment, selon le champ d'écran. Par contre, sa face isolante est par exemple à un potentiel VGM = -2 volts en raison de la charge positive en mémoire sur l'isolant après inscription (coefficient d'émission secondaire supérieur à 1). Le potentiel de l'écran étant par exemple de 25 kV, pour atteindre cet écran, les électrons vont traverser la grille mémoire, dans laquelle chaque élément de grille muni de son isolant, va constituer une microlentille électronique. L'ouverture de cette microlentille commandée par VGM et l'inclinaison des trajectoires électroniques sur la grille collectrice vont gouverner le passage des électrons à travers ces microlentilles. On définit ainsi un coefficient de transmission T1 de la grille mémoire. A pleine ouverture des microlentilles cette transmission est typiquement de 60%.

Le système d'effacement fonctionne pour des images récurrentes. Pour une image fixe, il convient de l'effacer après l'exposition de la laque photosensible. Dans ce cas, la polarisation du support de grille mémoire est portée au potentiel VGS = 0 volt tout en bloquant le canon d'inscription. Ainsi les charges sont neutralisées, l'isolant prend le potentiel de la cathode, et la cible est prête pour une nouvelle inscription. L'efffacement avec un canon d'arrosage spécifique est également possible.

Sur la figure 3, le faisceau d'électrons issu du canon d'arrosage arrive sur une mince couche d'aluminium 39, reliée à la très haute tension (THT), placée sur le luminophore 13 émettant dans l'ultraviolet déposé sur l'écran 17. Les dimensions du spot sur le luminophore sont de l'ordre de 60 micromètres. Les plaques de déflexion 32 agissent en synchronisme avec la console de visualisation. Pour disposer à la fois d'un temps d'exposition court et d'un contraste élevé, on opère en modulant d'une manière bistable la tension de grille (wehnelt). Ainsi avec une laque classique telle que la laque n° 1350 de la Société SHIPLEY, on obtient des temps d'exposition de l'ordre de 10 secondes. En réduisant ainsi le temps d'exposition, on diminue les imprécisions de restitution qui apparaissent généralement par les légères vibrations des systèmes d'insolation habituels.

Pour accroître les performances de haute brillance et d'homogénéité de brillance du tube, il est possible soit d'utiliser une cathode de plus grande dimension, qui nécessite une optique électronique de canon d'arrosage de même type que celui décrit mais de dimensions adaptées, soit d'utiliser plusieurs canons d'arrosage.

Selon une seconde variante il s'agit d'un tube à haute brillance dépourvu de la fonction mémoire, donc des canons d'arrosage et des grilles collectrice et à mémoire. La puissance électrique dissipée est alors plus faible de l'ordre de 60 watts. Pour obtenir une image stabilisée sur l'écran pendant la durée nécessaire à l'insolation, il faut utiliser un balayage récurrent. Avec la même laque que précédemment la durée d'exposition est de 30 secondes à 1 minute.

Le dispositif d'insolation qui vient d'être décrit selon deux variantes, permet de gagner des étapes dans la réalisation des circuits. Dans le cas des couches minces ou de substrats semiconducteurs, il permet d'insoler directement le substrat recouvert de sa laque photosensible. Dans le cas des couches épaisses il permet d'insoler les écrans de sérigraphie qui servent à déposer les encres.

## Revendications

1. Dispositif d'insolation pour la génération de masques à partir d'un système de conception assistée par ordinateur (20), qui comprend :
   - un tube à rayons cathodiques (10) qui fournit une image du masque sur l'écran (17) du tube,
   - et un système optique (12) qui projette l'image du masque sur un support à insoler (15),
   caractérisé en ce que
   - le tube à rayons cathodiques est un tube à haute brillance (10) dont l'écran est muni premièrement d'un luminophore (13) émettant dans l'ultraviolet, et deuxièmement d'un circuit (11) de refroidissement du luminophore,
   et en ce que le système optique est un système optique pour l'ultraviolet (12) qui opère sur l'image ultraviolette fournie par l'écran du tube à haute brillance (10).

2. Dispositif d'insolation selon la revendication 1,caractérisé en ce que le tube à haute brillance (10) est un tube à mémoire qui stocke une image latente du masque sur une grille à mémoire (34).

3. Dispositif d'insolation selon une des revendications 1 ou 2, caractérisé en ce que l'écran (17) du tube à haute brillance présente des repères de positionnement formés de petits plots d'un luminophore émettant dans le visible.

## Claims

1. An exposure arrangement for the production of masks using a computer-aided design system (20), which comprises :
   - a cathode-ray tube (10) which produces an image of the mask on the screen (17) of the tube,
   - and an optical system (12) which projects the image of the mask on to a substrate (15) which is to be exposed, characterized in that
   - the cathode-ray tube is a high-brightness tube (10) the screen of which is provided, first, with a phosphor (13) which emits in the ultraviolet spectrum and, second, with a cooling circuit (11) for the phosphor, and in that the optical system is designed for use in the ultraviolet spectrum (12) and operates on the ultraviolet image provided by the screen of the high-brightness tube (10).

2. An exposure arrangement as claimed in Claim 1, characterized in that the high-brightness tube (10) is a storage tube which stores a latent image of the mask on a storage grid (34).

3. An exposure arrangement as claimed in Claim 1 or 2, characterized in that the screen (17) of the high-brightness tube has reference marks in the form of small patterns of a phosphor which emit in the visible spectrum.

## Patentansprüche

1. Belichtungsvorrichtung zum Herstellen von Masken mit Hilfe eines computerunterstützten (20) Entwurfsystems, wobei diese Vorrichtung die nachfolgenden Elemente aufweist:

- eine Elektronenstrahlröhre (10), die am Schirm (17) der Röhre ein Bild der Maske erzeugt, und
- ein optisches System (12), das das Bild der Maske auf ein zu belichtendes Substrat (15) projiziert,
  dadurch gekennzeichnet, daß
- die Elektronenstrahlröhre eine Röhre hoher Helligkeit (10) ist, deren Schirm erstens mit einem Leuchtstoff (13) versehen ist, der im Ultraviolettbereich leuchtet, und zweitens mit einem Leuchtstoffkühlsystem (11) versehen ist,

und daß das optische System ein optisches System für den Ultraviolettbereich (12) ist, das mit dem Ultraviolettbild des Schirms der Röhre hoher Helligkeit (10) arbeitet.

2. Belichtungsvorrichtung nach Anspruch 1, dadurch gekennzeichnet, daß die Röhre hoher Helligkeit (10) eine Speicherröhre ist, die ein latentes Bild der Maske an einem Speichergitter (34) speichert.

3. Belichtungsvorrichtung nach einem der Ansprüche 1 oder 2, dadurch gekennzeichnet, daß der Schirm (17) der Röhre hoher Helligkeit Positionierungszeichen aufweist, die durch kleine im sichtbaren Bereich leuchtende Leuchtstofftüpfel gebildet werden.

FIG.1

FIG.2

FIG. 3

FIG. 4

FIG.5